(19) Europäisches Patentamt
European Patent Office
Office européen des brevets

(11) **EP 4 617 733 A1**

(12) **EUROPEAN PATENT APPLICATION**

(43) Date of publication:
**17.09.2025 Bulletin 2025/38**

(21) Application number: **25163916.7**

(22) Date of filing: **14.03.2025**

(51) International Patent Classification (IPC):
**G01V 1/20** (2006.01)    **G06N 20/00** (2019.01)
**G01V 1/30** (2006.01)    **G01V 1/34** (2006.01)

(52) Cooperative Patent Classification (CPC):
**G01V 1/20; G01V 1/302; G01V 1/345; G06N 20/00;**
G01V 2210/74

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.03.2024 US 202463565083 P**

(71) Applicants:
• **Services Pétroliers Schlumberger**
**75007 Paris (FR)**
Designated Contracting States:
**FR**

• **GeoQuest Systems B.V.**
**2514 JG The Hague (NL)**
Designated Contracting States:
**AL AT BE BG CH CY CZ DE DK EE ES FI GB GR
HR HU IE IS IT LI LT LU LV MC ME MK MT NL NO
PL PT RO RS SE SI SK SM TR**

(72) Inventors:
• **GALVAN, Edgar Leonardo**
**Houston, TX 77042 (US)**
• **MANZANO, David**
**Crawley, RH10 9BU (GB)**

(74) Representative: **Schlumberger Intellectual
Property Department
Parkstraat 83
2514 JG Den Haag (NL)**

(54) **UNSUPERVISED MACHINE LEARNING FOR SEISMIC FACIES CLASSIFICATION**

(57) Seismic facies modeling of an area of study at an oil and gas exploration site includes obtaining a seismic dataset. A set of unsupervised machine learning (USML) models processes a test dataset of the seismic dataset. Respective USML models of the set are configured with different cluster numbers. A USML model and corresponding elbow point cluster number is selected from the set of USML models. The selected USML model, configured with the elbow point cluster number, processes the seismic dataset to obtain clusters of the data points. Cluster profiles based on seismic cell attributes of the data points of each cluster are generated. Seismic facies labels are assigned to the clusters based on corresponding cluster profiles. The clusters are sampled to a three-dimensional (3D) grid representation of the area of study to obtain a seismic facies model displayed in a visualization tool of a seismic modeling platform.

**Description**

CROSS-REFERENCE TO RELATED APPLICATIONS

This application is a non-provisional application of, and thereby claims benefit under 35 U.S.C. § 119(e), to U.S. Provisional Application Serial No. 63/565,083 filed on March 14, 2024, which is incorporated herein by reference.

BACKGROUND

In regional oil and gas prospecting and exploration, seismic facies classification is performed to obtain insights into depositional settings and potential reservoir distribution. Seismic facies classification refers to the process of interpreting and categorizing different geological units based on their seismic reflection characteristics. This process helps geologists and geophysicists understand the depositional environment and the subsurface geology. Typically, when analyzing an exploration site, areas of study are selected within the exploration site and three-dimensional (3D) seismic volumes of the areas of study are analyzed. Seismic facies classification of these seismic volumes facilitates insights into depositional setting and potential reservoir distribution. Seismic facies classification benefits with machine learning (ML) assisted approaches, particularly in situations where well borehole information is limited.

A technical challenge arises in the use of classification based ML models for seismic facies classification. The extraction and identification of appropriate seismic facies labels for training data and preparation of training datasets may be expensive in terms of computing resources. Further, the training of supervised ML models may be expensive in computing resource usage and computing time. Other technical challenges may arise in results obtained using other methods. For example, using computed self-organizing maps may provide spatial uncertainties of results due to the translation of two-dimensional maps into 3D seismic volumes.

SUMMARY

In general, seismic facies modeling of an area of study at an exploration site includes obtaining a seismic dataset. Data points of the seismic dataset include one or more seismic cell attributes obtained from seismic data of the exploration site. A set of unsupervised machine learning (USML) models processes a test dataset of the seismic dataset. Respective USML models of the set are configured with different cluster numbers. The respective USML models process the test dataset. A USML model and corresponding elbow point cluster number is selected from the set of USML models to obtain a selected USML model and a corresponding elbow point cluster number. The selected USML model configured with the elbow point cluster number processes the seismic dataset to obtain clusters of the data points. Cluster profiles based on seismic cell attributes of the data points of each cluster are generated. Seismic facies labels are assigned to the clusters based on corresponding cluster profiles. The cluster profiles are further compared with geological data of the exploration site, to obtain geological descriptions for each labeled cluster. The clusters are sampled to a three-dimensional (3D) grid representation of the seismic data to obtain a seismic facies model. The seismic facies model is displayed in a visualization tool of a seismic modeling platform.

Other aspects of one or more implementations will be apparent from the following description and the appended claims.

BRIEF DESCRIPTION OF DRAWINGS

FIG. 1 shows a computing system, in accordance with one or more implementations.

FIG. 2 shows a data flow, in accordance with one or more implementations.

FIG. 3 shows a flowchart of a method, in accordance with one or more implementations.

FIG. 4 shows a flowchart of a method, in accordance with one or more implementations.

FIGS. 5.1 and 5.2 show examples of sampling a seismic volume to generate a 3D grid representation and corresponding linear datasets, in accordance with one or more implementations.

FIG. 6 shows an example of an elbow point obtained from a graph of distortion score versus cluster numbers, in accordance with one or more implementations.

FIG. 7 shows an example of cluster profiles as frequency distributions of seismic attributes, in accordance with one or more implementations.

FIG. 8 shows an example of a seismic image overlaid with a seismic facies model of a seismic volume, in accordance with one or more implementations.

FIGS. 9.1 and 9.2 show a computing system, in accordance with one or more implementations.

Like elements in the various figures are denoted by like reference numerals for consistency.

DETAILED DESCRIPTION

In general, unsupervised machine learning for seismic facies classification includes obtaining a seismic facies model of a geological area of study. The area of study may be in a regional oil and gas prospecting and exploration site. To generate the seismic facies model, a three-dimensional (3D) grid of seismic data is transformed into a linear representation data points. By using linear data points, more straightforward and efficient ML clustering techniques may be used. By performing the transformation and using the clustering techniques, the technical challenges of the extended duration of training classification ML models is addressed.

More specifically, the seismic facies model is obtained by sampling and extracting data points from the 3D grid representation of seismic volume imaging data. The sampled and extracted data points are stored in a linear representation as having 3D coordinates (*i.e.*, seismic cell coordinates) and selected attributes (*i.e.*, seismic cell attributes). The linear representation form of the sampled data points are clustered with an unsupervised machine learning (USML) model using a corresponding cluster number. In one or more embodiments, the USML model may be a partition-based model. Partition-based models organize data into distinct groups or clusters without using labeled data. A goal of partition-based models may be to find patterns or structures within the data The particular USML model and particular cluster number are selected by using a test dataset of the data points to test USML models. The selection of the USML model and corresponding cluster number may be performed using the elbow method and silhouette scoring. The elbow method ascertains the cluster number for a particular USML model to cluster the test dataset, based on the distortion of the data points in a cluster. The silhouette score determines the degree of similarity between data points within a cluster and the degree of difference between individual clusters. The elbow method and silhouette score constitute a complementary evaluation and validation system of the USML model and corresponding cluster number.

The selected USML model clusters the dataset of data points sampled from the 3D grid representation into the determined cluster number. A cluster profile, which is a distribution of attributes of the data points within a cluster relative to the attribute distribution of the dataset, is obtained. Based on the cluster profile of a cluster, and geological data of the exploration site, the cluster is assigned a seismic facies label. Corresponding descriptions of seismic facies labels obtained from the geological data are paired to the labeled clusters. Thus, the USML model may generate seismic facies classifications of the clusters, while ensuring low variance between the data points within a cluster and well-defined separation of clusters. Notably, the dataset may not be labeled with seismic facies labels, and the USML model is not pre-trained on the dataset. Thus, the clustering is unsupervised.

The labeled clusters are resampled back to the 3D grid representation of the seismic imaging data at the resolution of the seismic imaging data, to reveal seismic facies geometry of the area of study. The seismic facies geometry is the seismic facies model. Thus, the exploration site is mapped to USML-identified seismic facies, resulting in a seismic facies model of the area of study. The seismic facies model may be further used for well-path design and positioning, 3D visualization, and generation of drilling plans for the exploration site.

By using the above approach, the resulting classification is accurate and generates well-defined classes for the dataset. Further, the USML models may be selected from extant USML platforms with pre-trained USML models, avoiding the need for extensive labelling of training data and further, extensive re-training of machine learning models.

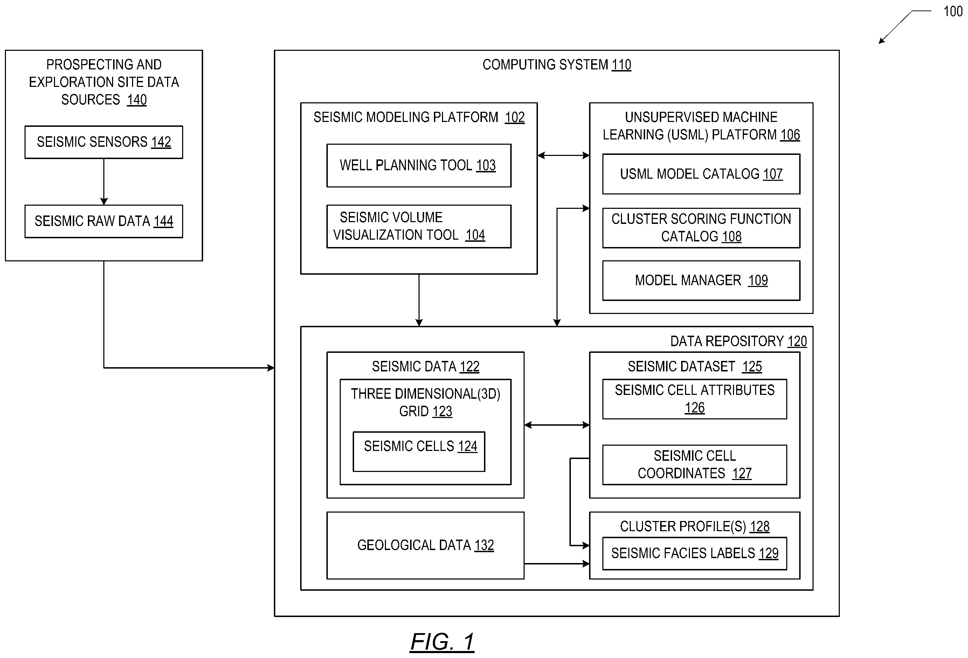

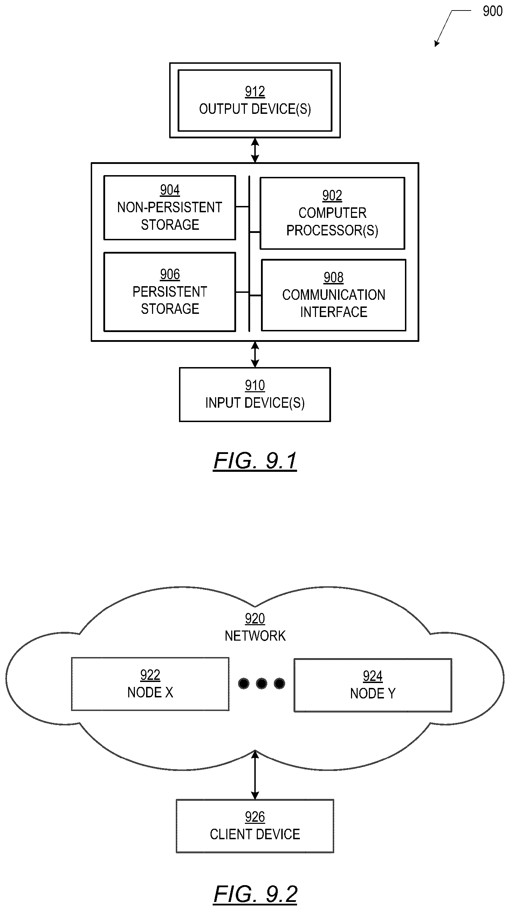

Attention is now turned to the figures. FIG. 1 shows a system 100, in accordance with one or more embodiments. As shown in FIG. 1, computing system (110) is one or more computer processors, data repositories, communication devices, and supporting hardware and software. The computing system (110) may be in a distributed computing environment. The computing system (110) is configured to execute one or more applications, such as the seismic modeling platform (102), and the unsupervised machine learning (USML) platform (106). An example of a computer system and network that may form the computing system (110) is described with respect to FIG. 9.1 and FIG. 9.2. The computing system (110) includes one or more computer processors. The computer processors are one or more hardware or virtual processors which may execute computer readable program code that defines one or more applications, such as the seismic modeling platform (102), and the USML platform (106). An example of the computer processor is described with respect to the computer processor(s) (902) of FIG. 9.1.

The system 100 shown in FIG. 1 includes prospecting and exploration site data sources (140). The prospecting and exploration site data sources (140) may further include seismic sensors (142), which collect seismic raw data (144). As a brief overview, seismic raw data (144) refers to the information collected from seismic surveys which are used to map and understand the subsurface of the Earth. Seismic surveys involve generating seismic waves (usually through controlled sources like explosives or specialized equipment) and recording how these waves travel through different geological layers. The seismic sensors (142) may be devices such geophones or hydrophones. The seismic sensors (142) may be used to detect the seismic waves as they return to the surface. The seismic sensors (142) may record the time taken for the waves to travel through the subsurface and return. In phenomena known as seismic reflection and refraction, the seismic waves reflect off different geological layers and structures, providing information about the depth, composition, and shape of these layers.

The computing system (110) shown in FIG. 1 further includes a seismic modeling platform (102). The seismic modeling platform may further include at least a well planning tool (103) and a seismic volume visualization tool (104). The seismic modeling platform (102) is software or application-specific hardware which, when executed by the computer processor, performs subsurface modeling and simulation for oil and gas prospecting and exploration sites. Functions and features of the seismic modeling platform (102) may include analysis of subsurface data, creation of reservoir models, interpretation of seismic data, and well plan development strategies. The seismic modeling platform (102) may facilitate collaborative workflows between teams of geoscientists and engineers from exploration to production. Thus, the seismic modeling platform (102) is a geoscience and reservoir engineering software platform. Examples of geoscience and reservoir engineering software platforms include Petrel® from Schlumberger Limited, Jason® from Emerson Electric Co., Pathview® and WellArchitect® from Dynamic Graphics, Inc.

The seismic volume visualization tool (104) is software or application-specific hardware, which, when executed by the computer processor, performs seismic volume rendering and extraction. Seismic volume rendering and extraction refer to a process used in geophysical interpretation to visualize and analyze 3D seismic data. A seismic volume refers to a 3D grid representation of seismic survey data collected from seismic survey operations. The 3D grid may be visualized and analyzed to interpret geological features such as faults, stratigraphic layers, and potential hydrocarbon reservoirs. Seismic volumes may be used for oil and gas exploration and production, and further, in earthquake seismology and environmental studies.

The seismic volume visualization tool (104) may include features of volume blending and rendering. Further, the seismic volume visualization tool (104) may include features of geobody extraction, entailing the interactive isolation and extraction of geobodies. Geobodies refer to 3D objects representing geological features. Further, the seismic volume visualization tool (104) may include features for attribute extraction and analysis from the 3D grid representation of the seismic volume. Attribute extraction and analysis may entail cross-plotting of multiple seismic attributes for classification or quantitative interpretation workflows.

An example of the seismic volume visualization tool (104) may be the seismic volume rendering and extraction module in Petrel® subsurface software (Petrel® is registered trademark of Schlumberger Limited). Another example may be the advanced seismic reservoir characterization suite of Jason®.

The seismic modeling platform (102) may further include a well planning tool (103). The well planning tool (103) is software or application-specific hardware, which when executed by a computer processor, performs planning of well paths based on seismic facies models of seismic volumes, geological data of the area of study, and other inputs. For example, the well planning tool (103) may include features for evaluating wellbore stability, offset well analysis, and relief well planning in the broader task of trajectory planning. The well planning tool (103) may further include features for anticollision analysis, to ensure that planned well paths avoid existing wells and other subsurface hazards, particularly in congested offshore and land development environments. Other features such as real-time drill monitoring of drilling operations, facilitating immediate changes to well planning based on actual drilling data may be included. Examples of the well planning tool (103) may include the well planning modules of Petrel, Jason, WellArchitect and Pathview.

The computing system (110) shown in FIG. 1 further includes a USML platform (106). The USML platform (106) further includes a USML model catalog (107), a cluster scoring function catalog (108), and a model manager (109). The USML platform (106) is software or application-specific hardware, which, when executed by a computer processor, performs data preparation, machine learning, and AI tasks. Users of the USML platform (106) may connect, cleanse, and prepare data, build, and deploy machine learning models, and create interactive visualizations within the platform. More particularly, the USML platform (106) includes the USML model catalog (107) which includes one or more USML models. Notably, the USML models may not be pre-trained in the same way as supervised machine learning models or image classification models. Examples of USML models in the USML model catalog (107) may include K-means clustering, Hierarchical clustering, Gaussian mixture models, *etc.*

The USML platform (106) may include features for users to select USML models from the USML model catalog (107) and set up and run the USML models. The model manager (109) of the USML platform (106) may include features for users to provide minimal configuration parameters, such as sampling, feature selection, dimensionality reduction, and outlier detection. Further, the model manager (109) of the USML platform (106) may include features to automatically select the best feature importance vectors, algorithms, and hyperparameters for running the selected USML model.

The cluster scoring function catalog (108) includes one or more functions for scoring the clustered output of a particular USML model. For example, the cluster scoring function catalog (108) may include distortion calculating functions, to calculate the distortion of data points within a cluster. Another example may be a silhouette scoring function, to calculate the degree of similarity between data points within a cluster and the degree of difference between individual clusters. Another example may be an elbow point calculation function, which calculates an elbow point of a gradient improvement in the distortion scores of a USML model set to run with a range of varying cluster numbers.

An example of the USML platform (106) may be Dataiku. Other examples may include DataRobot, Amazon SageMaker, Alteryx, Vertex AI, H2O.ai, *etc.*

The computing system (110) shown in FIG. 1 includes a data repository (120). The data repository (120) is a type of storage unit or device (*e.g.,* a file system, database, data structure, or any other storage mechanism) for storing data. The data repository (120) may include multiple different, potentially heterogeneous, storage units. The data repository (120) may further include multiple physical storage devices. The data repository (120) includes seismic data (122). The seismic data (122) includes one or more 3D grid (123) structures. The 3D grid (123) structures are 3D grid representations of diverse seismic volumes of a particular area of study. The area of study may be a particular region of an oil and gas prospecting and exploration site. The 3D grid (123) structures may include one or more seismic cells (124). The seismic cells (124) are individual units of a 3D grid (123) structure. The terms "3D grid structure" and "3D grid representation" are interchangeably used in the current specification.

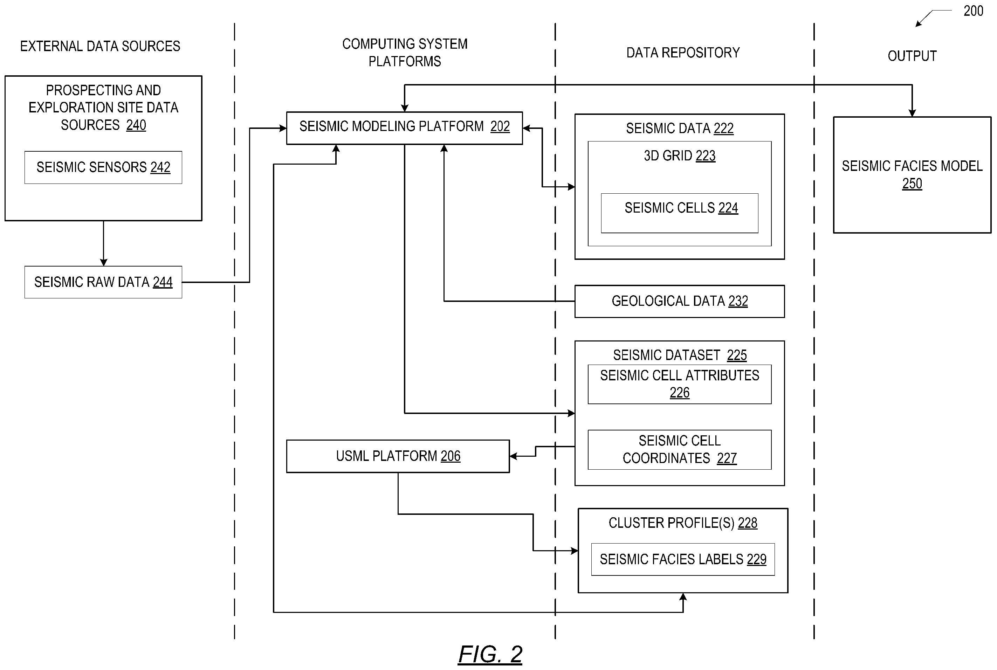

As a brief overview, a 3D grid representation of a seismic volume is a way to visualize and interpret seismic data in three dimensions. Generation of a 3D grid representation involves dividing the seismic volume into a grid of small, contiguous subareas, called stacking bins. Each stacking bin may contain seismic traces that represent the reflected seismic waves from different geological layers. A seismic cell of a 3D grid is the smallest unit within the 3D grid. It is a volumetric element that holds seismic data for a specific location in the seismic volume. A seismic cell may be cuboid in shape, defined by dimensions in the x, y, and z directions. Each seismic cell contains information about the seismic properties at that point, such as velocity, density, and reflectivity, in other words, one or more seismic attributes. The stacking bin and seismic cells of the 3D grid facilitate analysis of seismic traces for rendering detailed 3D images of the seismic volume, and further, interpretation of the geological structures and properties of the seismic volume. The 3D grid (123) may be stored in various formats in the data repository (120), for example, a volume data store, a 3D seismic data cube, *etc.* 3D seismic data cubes provide enhanced structural and stratigraphic information compared to 2D seismic data. The 3D grid (123) structure and the seismic cell (124) are described in further detail in reference to FIG. 2.

The data repository (120) further includes one or more seismic dataset(s) (125). The seismic dataset includes one or more data points. Each data point is characterized by seismic cell attributes (126) and corresponding seismic cell coordinates (127). The seismic cell attributes (126) may include seismic attributes such as amplitude, instantaneous frequency (IF), instantaneous phase (IP), relative acoustic impedance (RAI), *etc.* The seismic cell coordinates (127) are the cardinal coordinates of a seismic cell (124), denoting the position of the seismic cell (124) within the 3D grid (123) structure. A seismic dataset (125) may correspond to a 3D grid (123) structure. Likewise, the seismic cell attributes (126) and seismic cell coordinates (127) may correspond to a seismic cell (124) of the 3D grid (123) structure. The seismic dataset (125) may be stored in linear data structures, for example, comma-separated values (CSV) files. Each row of the CSV file may represent a data point. Columns of a particular row may include the seismic cell coordinates (127) of a data point, namely, X, Y, and Z cardinal coordinates. Further, the columns may include the seismic cell attributes (126). Parquet is another example of a columnar storage file format for seismic datasets.

The data repository (120) further includes geological data (132) related to various areas of study of the oil and gas prospecting and exploration site obtained from means and processes other than seismic surveying operations. For example, the geological data (132) may include well log data. Well log data may include a detailed record of geological formations penetrated by a borehole, providing information on rock properties such as porosity, permeability, and lithology. In another example, the geological data (132) may further include core sample data of a rocks physical and chemical properties, such as mineral composition, sedimentary structures, and grain size. Further examples of other types of data included in geological data (132) may include geochemical data, petrophysical data and geomechanical data. The geological data (132) may be stored in a geodatabase such as Esri, and PostGIS. Other examples of data storage for geological data include Shapefiles, Network Common Data Form (NetCDF) relating to array-oriented scientific data, Hierarchical Data Format Version 5 (HDF5), *etc.*

The data repository (120) further includes one or more cluster profile(s) (128). The cluster profile(s) (128) may be further annotated with seismic facies labels (129). The cluster profiles (128) are seismic attribute profiles of a cluster of data points. The cluster of data points may be output by a USML model processing the seismic dataset (125) of data points. The seismic facies labels (129) may be labels obtained from the geological data (132) classifying the one or more cluster profile(s) (128). A particular cluster profile (128) may include frequency distributions of attributes of the data points in the cluster. In one example, cluster profile(s) (128) may be stored as Javascript Object Notation (JSON) objects and/or documents.

While FIG. 1 shows a configuration of components, other configurations may be used without departing from the scope of one or more embodiments. For example, various components may be combined to create a single component. As another example, the functionality performed by a single component may be performed by two or more components.

FIG. 2 shows a data flow diagram (200) showing causal relationships between the components of the computing system (110) of FIG. 1 and the components of the data repository (120) of FIG. 1, in accordance with one or more embodiments. The blocks of FIG. 2 correspond to like-named and numbered blocks of FIG. 1. For instance, Block 202 of FIG. 2 corresponds to Block 102 of FIG. 1. Likewise, Block 206 of FIG. 2 corresponds to Block 106 of FIG. 1. Similarly, Blocks 222, 225, and 228 of FIG. 2 and their corresponding sub-blocks of FIG. 2 correspond respectively to Blocks 122, 125, and 128 of FIG. 1 and their corresponding sub-blocks of FIG. 1. Further, Block 240 and its corresponding sub-blocks of FIG. 2 correspond respectively to Blocks 140 and its corresponding sub-blocks of FIG. 1.

FIG. 2 shows the flow of seismic raw data passing through the stages of data collection, pre-processing, data representation, data clustering, data resampling and lastly, as output as a seismic facies model of a seismic volume. The seismic volume may be the seismic volume data of an area of study in a regional oil and gas prospecting and exploration site.

In an initial phase of the data flow, seismic raw data (244) is received by the seismic modeling platform (202). The seismic raw data (244) may be pre-processed. Pre-processing may entail several steps. Initial checks may include verifying the integrity of the data, checking for missing traces, and identifying any noise or artifacts. Further, filters such as band-pass filtering, dip filtering, and coherent noise attenuation may be applied to remove unwanted noise from the seismic data. The resolution of the seismic data may be enhanced by compressing the seismic wavelet to improve the temporal resolution of the seismic traces. Variation correction may be performed for variations in the elevation of the recording instruments and the near-surface velocity variations. Velocity analysis may be performed to determine the seismic velocities of the subsurface layers, used for accurate depth conversion and stacking. Normal Moveout (NMO) correction may be applied to account for the difference in travel time of seismic waves at different offsets to align the seismic reflections for stacking. In the stacking operation, multiple seismic traces may be combined from different offsets to create a single trace, to enhance the signal-to-noise ratio and produce a clearer seismic image. Further, a migration step may be performed. Migration may correct for the effects of dipping reflectors and diffractions. Migration repositions the seismic events to their true subsurface locations, improving the spatial resolution of the seismic image. Thus, seismic raw data (244) is converted to a processed seismic volume.

In a next phase of the data flow, one or more 3D grid(s) (223) are constructed from the processed seismic volume by the seismic modeling platform (202). In constructing a 3D grid, the processed seismic volume is divided into a 3D grid of seismic cells (224). Each seismic cell (224) may include seismic attributes such as amplitude, phase, and frequency, representing the subsurface properties at that location. The one or more 3D grid(s) (223) constitute the seismic data (222). Notably, the seismic cells (224) may be sampled from the processed seismic volume.

Sampling the seismic cells (224) may entail selecting a vertical section of the seismic volume between two specific geological surfaces, and dividing the vertical section into a multitude of layers. The seismic cells (224) may be sampled according to an initial stackable bin size to organize the data into manageable units. In seismic data acquisition and processing, bin size refers to the horizontal dimensions of the smallest unit of area into which the seismic data is divided for analysis. Bin size is essentially the size of the grid cells used to organize and process the seismic data.

The seismic cells (224) may be resampled or interpolated to convert the initial stackable bin size to a different table size of the desired 3D grid resolution or size. An interpolation method (*e.g.,* linear, spline, *etc.*) may be selected based on the type of the data of the seismic cells (224) and the desired resolution. For example, adjusting from a bin size of 12.5 x 12.5 meters to a 30 x 30 meter grid cell size involves resampling the seismic data. The data may be combined from multiple smaller bins (12.5 x 12.5 meters) into larger bins (30 x 30 meters). This process may involve averaging or summing the data values within the new, larger bins. Interpolation techniques may be used to estimate the data values at the new grid points. A new 3D grid (223) may be created with the desired 30 x 30 meter cell size. The aggregated and/or interpolated data may be mapped onto the new grid, with the new seismic cell size. The new grid may be used as the 3D grid (223) from which the data points corresponding to the seismic cells (224) are generated.

In a next phase of the data flow, the seismic data (222) including the 3D grid (223) may be used by the seismic model platform (202) to generate a seismic dataset (225). Generation of the seismic dataset (225) from the 3D grid (223) may involve attribute extraction, in which seismic attributes are extracted from seismic cells (224) of the 3D grid (223). The seismic attributes may include instantaneous frequency, instantaneous phase, and relative acoustic impedance, *etc.,* which are examples of post-stack seismic attributes. A post-stack seismic attribute is a characteristic derived from seismic data after the seismic traces have been stacked. Stacking is a process where multiple seismic traces are combined to enhance the signal-to-noise ratio. Post-stack attributes may be used to interpret and analyze subsurface geological features. Other seismic attributes may be extracted. Additionally, seismic cell coordinates of the seismic cells may be extracted from the 3D grid (223).

A suitable data structure format may be selected for the seismic dataset (225), for example, a table. Each row of the table may represent a data point representing a seismic cell (224). The columns may include the seismic attributes (226) of the seismic cell (224). The columns of the row representing the data point may further include the seismic cell coordinates (227) of the seismic cell (224).

In a next phase of the data flow, the seismic dataset (225) may be processed by the USML platform (206). In processing the seismic dataset (225), the USML platform (206) may be used to select a set of USML models. Each of the selected USML models may be evaluated by processing a sample, or test dataset of the seismic dataset (225), with a varying range of clusters. The range of clusters refers to a range of cluster numbers. A cluster number is a configuration parameter of a USML model that specifies the number of clusters the USML needs to create from an input dataset. For example, a USML model may cluster a test dataset of a seismic dataset (225) into a range of cluster numbers, {2,4,5,7,8,9}. In a first iteration, the USML model may cluster the data points of the test dataset into two clusters. In the next iterations, the USML model may successively cluster the data points of the test dataset into four, five, seven, eight, and nine clusters, respectively.

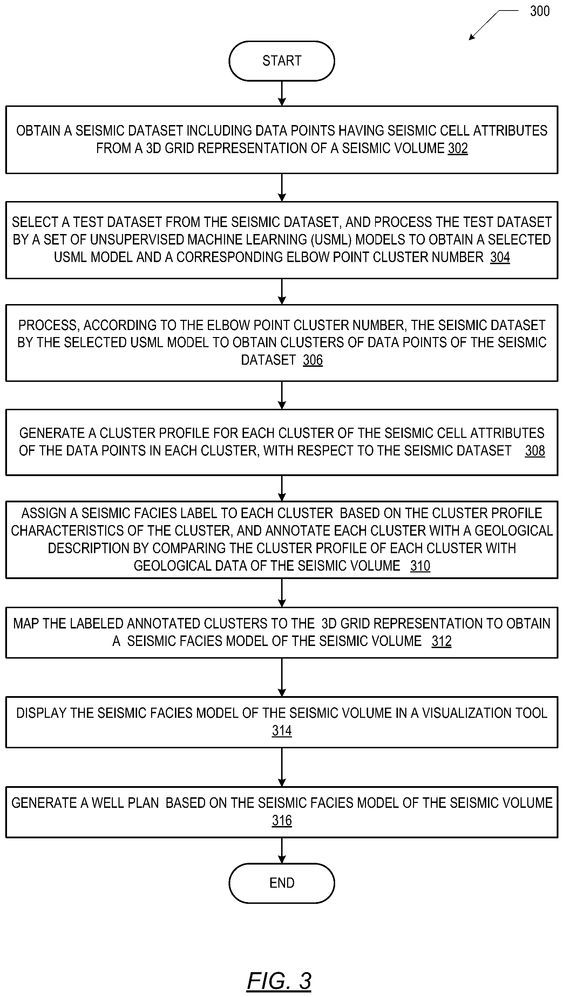

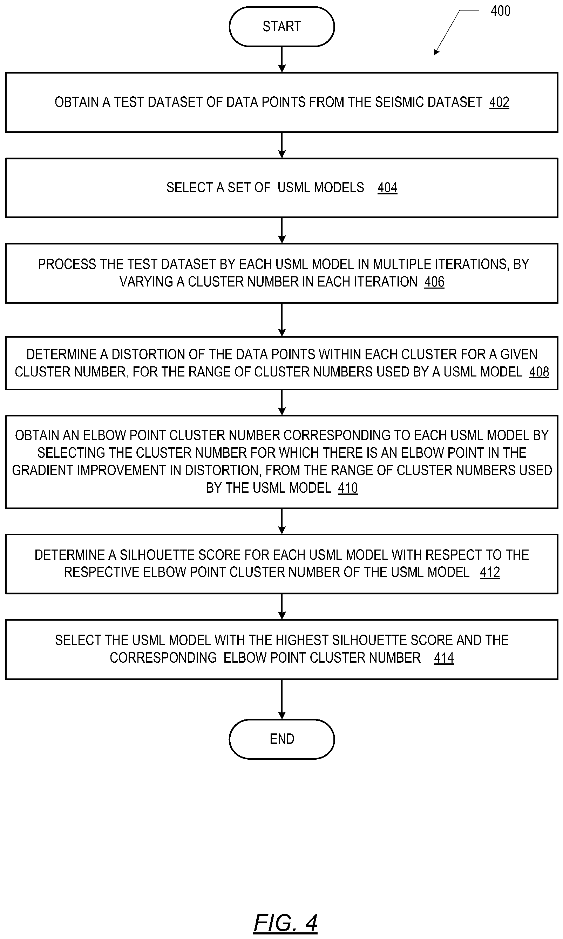

Each selected USML model may process the test dataset in a similar manner. The evaluation of each USML model performance results in one USML model being selected to process the seismic dataset (225) into a corresponding selected cluster number. The selection and evaluation process of the USML models is described in further detail in reference to FIGS. 3 and 4.

The USML model platform (206) may process the seismic dataset (225) by the selected USML model to generate a set of clusters of the data points of the seismic dataset (225). The cardinality of the set of clusters matches the corresponding selected cluster number. Further, the USML model platform (206) may generate frequency distributions of one or more seismic attributes of the data points in each cluster of the set of clusters. A frequency distribution of a particular seismic attribute of the data points constitutes a cluster profile. Thus, a cluster may have one or more cluster profile(s) (228) corresponding to one or more seismic attributes of the data points of the cluster.

In a next phase of the data flow, the seismic modeling platform (202) may receive the cluster profiles (228) and characterize the cluster profiles (228) based on geological data (232). For example, a cluster profile of an amplitude seismic attribute of the data points within a particular cluster may be compared to geological data (232) characterizing various geological features, such as faults, folds, and stratigraphic layers. Based on this comparison and analysis, the particular cluster profile may be assigned a seismic facies label (229). A seismic facies label (229) refers to a label identifier based on the seismic attribute(s) of the frequency distribution of the particular cluster profile. For example, a seismic facies label "Parallel low amplitude - high frequency" may be assigned to a cluster profile having a particular frequency distribution with respect to amplitude and frequency seismic attributes of the data points of the cluster. Further, the seismic facies label "Parallel low amplitude - high frequency" may be additionally annotated with a geological description obtained from the geological data, for example, "Basin plain - no reservoir."

As a brief overview, seismic facies are mappable, three-dimensional seismic units composed of groups of reflections that have distinct characteristics compared to adjacent units. The characteristics, or attributes, may include parameters such as reflection geometry, referring to the shape and arrangement of seismic reflections, and continuity, referring to the lateral consistency of seismic reflections. Other attributes may include amplitude, which is the strength of the seismic signal, and frequency, which is the number of seismic wave cycles per unit of time. Another attribute may be interval velocity, which is the speed at which seismic waves travel through the subsurface layers of the seismic volume.

In a next phase of the data flow, the seismic modeling platform (202) may use the classified and annotated cluster profiles (228) to visualize and interpret the 3D seismic volume. More particularly, the classified and annotated clusters may be resampled back to the 3D grid. In an example implementation, a new 3D grid may be initialized with the same dimensions at the original 3D grid (223). The seismic facies labels corresponding to clusters may be propagated to each data point of the cluster. The data points may be mapped back to seismic cells of the new 3D grid based on their coordinate information. For example, if a data point has seismic cell coordinates (X1, Y1, Z1), then a seismic cell in the new 3D grid with cardinal coordinates (X1, Y1, Z1), with respect to the new 3D grid may be located. A mapping may be established between the data point and the seismic cell. In a visualization and interpretation step, the labeled 3D grid may be loaded into the visualization tool of the seismic modeling platform (202) and may be visualized using different techniques. For example, different seismic facies labels of data points may be highlighted with distinct colors to produce the seismic facies model (250) of the seismic volume as the output. Further analysis may be performed to identify geological features, such as faults, folds, and stratigraphic layers.

FIG. 3 shows a flowchart 300 of a method for creating a well plan based on a seismic facies model of a seismic volume, in accordance with one or more embodiments. The method of FIG. 3 may be implemented using the system of FIG. 1 and one or more of the steps may be performed on or received at one or more computer processors. While the various steps in flowchart 300 are presented and described sequentially, at least some of the steps may be executed in different orders, may be combined, or omitted, and at least some of the steps may be executed in parallel. Furthermore, the steps may be performed actively or passively.

In Block 302, a seismic dataset including data points having seismic attributes from a 3D grid representation of a seismic volume is obtained. In one or more embodiments, the seismic dataset is obtained from seismic data of an exploration site. The seismic dataset may include a multitude of data points. A data point may include one or more seismic attributes. In one or more embodiments, data points may be sampled from the 3D grid representation of the seismic volume. In particular, a seismic cell of the 3D grid representation may be sampled. Further at least a seismic cell attribute of the seismic cell may be obtained. In one or more embodiments, the seismic cell attribute(s) may include seismic amplitude, relative acoustic impedance, envelope, instantaneous frequency, instantaneous phase, *etc.*. The "envelope" in seismic cell attributes, also known as instantaneous amplitude, represents the amplitude of a seismic signal at any given point in time. The seismic cell attributes may include other post-stack seismic attributes. A post-stack seismic attribute is a characteristic derived from seismic data after the seismic traces have been stacked. Stacking is a process where multiple seismic traces are combined to enhance the signal-to-noise ratio. Post-stack attributes may be used to interpret and analyze subsurface geological features. Further, seismic cell coordinates of the seismic cell with respect to the 3D grid may be obtained. The seismic cell coordinates and the seismic cell attribute(s) constitute a data point. Thus, the data point is a linear representation of the seismic cell, including the seismic cell attribute(s) and the seismic cell coordinates. The dataset including the data points is obtained in this manner.

In Block 304, a test dataset is selected from the seismic dataset, and the test dataset is processed by a set of USML models to obtain a selected USML model and a corresponding elbow point cluster number. In one or more embodiments, the test dataset including a multitude of test data points may be selected from the seismic dataset. Further, a USML model from a set of USML models may be selected. The USML model may be selected by processing the test dataset with the set of USML models. Respective USML models of the set of USML models may be configured with a multitude of cluster numbers. Upon processing the test dataset with the set of USML models, a selected USML model and a corresponding elbow point cluster number may be obtained.

Processing the test dataset with the USML models is an evaluation process of the USML models. A goal of the evaluation process is to automatically ascertain a USML model configured with a particular cluster number, which may output clusters in which the data points have a lowest intra-cluster distance and a highest nearest cluster distance. In other words, the data points within a cluster are most similar, and the data points of different clusters are least similar. These properties of the data points of the clusters are evaluated based on the elbow point method and silhouette scoring. A detailed description of automatic selection of the USML model and corresponding elbow point cluster number is provided in reference to FIG. 4. Thus, in one or more embodiments, Block 304 may be performed by the method of FIG. 4.

In Block 306, the seismic dataset is processed according to the elbow point cluster number by the selected USML model to obtain clusters of data points of the seismic dataset. In one or more embodiments, the seismic dataset may be processed by the selected USML model, configured with the corresponding elbow point cluster number, to obtain clusters of the data points. The number of clusters, or a count of the clusters, is the corresponding elbow point cluster number of the selected USML model. Stated another way, the selected USML model processes the seismic dataset and outputs a set of clusters. The cardinality of the set of clusters is the elbow point cluster number. For example, if the selected USML model is a K-means clustering model, and the elbow point cluster number is 6, then the K-means clustering model will output a set of 6 clusters.

In Block 308, a cluster profile is generated for each cluster of the seismic cell attributes of the data points in each cluster with respect to the seismic dataset. In one or more embodiments, cluster profiles corresponding to the clusters of the data points may be generated. The cluster profile may be based on seismic cell attributes of the data points of each cluster. In one or more embodiments, the cluster profile may be a frequency distribution of the seismic cell attributes of the data points of a cluster.

In Block 310, a seismic facies label is assigned to each cluster based on the cluster profile characteristics of the cluster. Further, each cluster is annotated with a geological description by comparing the cluster profile of each cluster with geological data of the exploration site. In one or more embodiments, the geological data may include geological data to the seismic volume represented by the 3D grid. In one or more embodiments, a seismic facies label may be assigned to each cluster of the data points based on the corresponding cluster profile to obtain labeled clusters of the data points. Further, the cluster profiles may be compared with geological data of the exploration site, in particular, the geological data of the seismic volume to obtain a geological description for each labeled cluster. Each labeled cluster may be annotated with the geological description to obtain labeled annotated clusters.

In Block 312, the labeled annotated clusters are mapped to the 3D grid representation to obtain a seismic facies model of the seismic volume. In one or more embodiments, the labeled and annotated clusters may be sampled to the 3D grid representation of the seismic data to obtain a seismic facies model of the seismic volume. More specifically, the labeled, annotated clusters may be resampled back to the 3D grid representations and overlaid on the seismic volume at the resolution of the seismic data of the seismic volume.

In one or more embodiments, resampling may be performed as described in reference to the data flow diagram of FIG. 2. Further, re-sampling may entail handling overlaps (multiple data points mapping to the same seismic cell) or gaps (seismic cells without corresponding data points). Overlaps and gaps may be addressed by applying interpolation or averaging techniques to ensure a smooth and continuous seismic facies model. For example, for overlaps, averaging the labels and annotations or selecting the most representative label may be performed. For gaps, interpolation based on neighboring cells may be performed.

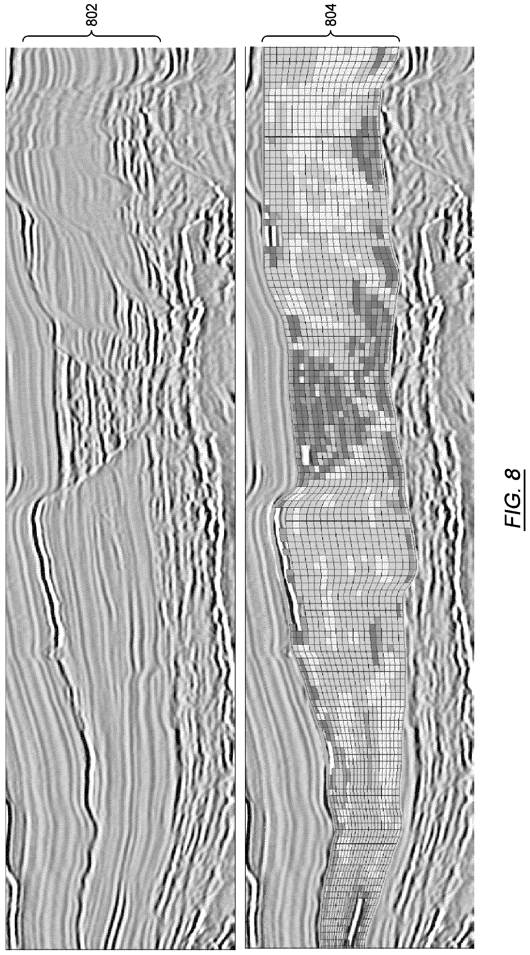

In Block 314, the seismic facies model of the seismic volume is displayed in a visualization tool. In one or more embodiments, the seismic facies model may be displayed in the visualization tool of a seismic modeling platform, for example, Petrel, Jason, *etc.* An example of the seismic facies model of a seismic volume overlaid on a seismic image is shown in, and described with reference to, FIG. 8.

In Block 316, a well plan is generated based on the seismic facies model of the seismic volume. In one or more embodiments, the seismic modeling platform may generate a well map based on a multitude of seismic facies models. The seismic facies models may correspond to a multitude of seismic volumes of diverse areas of study of the exploration site.

FIG. 4 shows a flowchart 400 of a method for automatically selecting a USML model and corresponding elbow point cluster number based on evaluating a set of USML models processing a test dataset, in accordance with one or more embodiments. In one or more embodiments, the method of FIG. 4 may be triggered in Block 304 of FIG. 3. The method of FIG. 4 may be implemented using the system of FIG. 1 and one or more of the steps may be performed on or received at one or more computer processors. While the various steps in flowchart 400 are presented and described sequentially, at least some of the steps may be executed in different orders, may be combined, or omitted, and at least some of the steps may be executed in parallel. Furthermore, the steps may be performed actively or passively.

In Block 402, a test dataset including a multitude test data points is obtained from the seismic dataset.

In Block 404, a set of USML models are selected. In one or more embodiments, a first USML model may be further selected from the set of USML models.

In Block 406, the test dataset is processed by the USML models in multiple iterations, by varying a cluster number in each iteration. In one or more embodiments, a selected cluster number corresponding to the first USML model may be set to a first cluster number from a range of cluster numbers. Further, the first USML model may generate a first set of clusters of test data points. The cardinality of the first set of clusters is the selected cluster number. For example, if the cluster number is set to 6, from a range of cluster numbers {6, 8, 10, 12}, then the first USML model may generate a set of clusters, C = {C1, C2, C3, C4, C5, C6}. The cardinality of the set C is 6, the selected cluster number.

In Block 408, a distortion of the data points within each cluster is determined for a given cluster number, for the range of cluster numbers used by a USML model. In one or more embodiments, the distortion of the data points in a cluster may be determined in accordance with Equation 1:

$$J(c, \mu) = \sum_{i=1}^{m} \left\| x^i - \mu_c \right\|^2 \tag{1}$$

In Equation (1), $J$ is the sum of squared distances, or distortion. $x^i$ is the seismic cell coordinates of the data point $i$. $\mu_c$ is the cluster centroid. $m$ is the number of data points in the cluster. $C$ is the cluster number, *e.g.,* 4, 5, 6, 8, *etc.* Thus, for example, if $C$ is 4, then the centroid of each of the four clusters output by a particular USML model is determined. The distortion of each test data point with respect to the centroids of the four clusters is calculated. The distortion values of all the test data points are summed to obtain a distortion score for four clusters output by the particular USML model. In one or more embodiments, a distortion of the test data points within each cluster of the first set of clusters is calculated, to obtain a first distortion value corresponding to the selected cluster number.

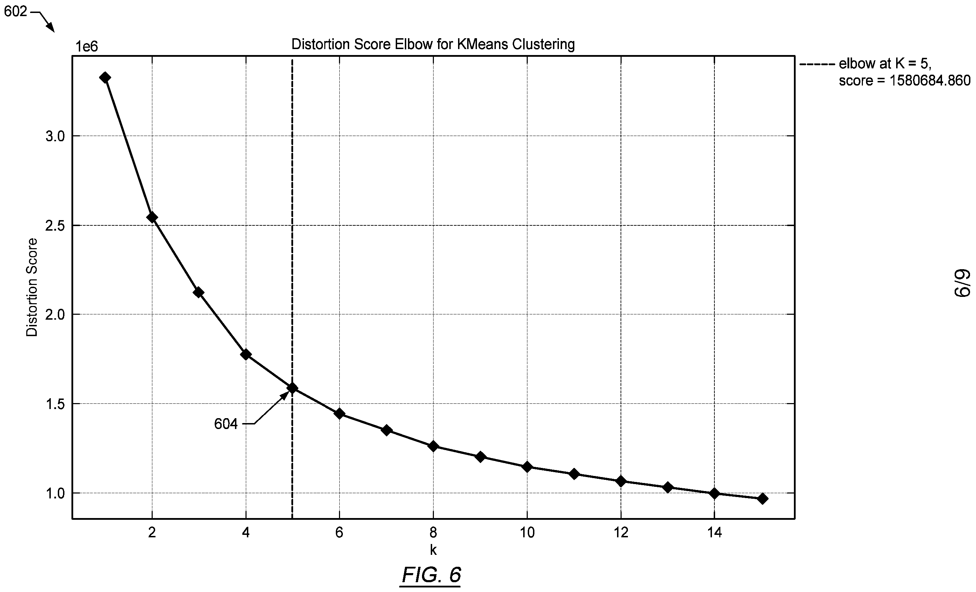

The distortion scores corresponding to the range of cluster numbers may be plotted on a graph for the particular USML model. The graph may resemble an arm and elbow, with the "elbow point" indicating the value of the cluster number where the distortion starts decreasing at a lower rate. This point represents the optimal number of clusters to best cluster the data. An example of an elbow point in the graph of distortion values versus cluster numbers is shown in FIG. 6.

Accordingly, in Block 410, an elbow point cluster number corresponding to each USML model is obtained. The elbow point cluster number is the cluster number for which there is an elbow point in the gradient improvement in distortion from the range of cluster numbers used by the USML model. In one or more embodiments, the processing of the test dataset by the first USML model may be iterated. The selected cluster number may be set to successive cluster numbers from the range of cluster numbers in each iteration. A set of distortion values corresponding to the range of cluster numbers may be obtained from the iterations. The elbow point cluster number may be determined based on the set of distortion values. Each USML model may be evaluated with the test dataset in accordance with the steps of Blocks 406-410. Further, a set of elbow point cluster numbers corresponding to the set of USML models may be obtained based on sets of distortion values corresponding to respective USML models of the set of USML models.

In Block 412, a silhouette score for each USML model with respect to the respective elbow point cluster number is determined. In one or more embodiment, the silhouette score of a USML model may be determined in accordance with Equation 2:

$$s(i) = \frac{b(i) - a(i)}{\max\{a(i), b(i)\}} \tag{2}$$

In Equation (2), $s(i)$ is the silhouette score for each data point $i$. $a(i)$ is the mean intra-cluster distance of data points within a cluster. $b(i)$ is the smallest mean distance to all points in any other cluster, in other words, not within the cluster. Notably, the other clusters include clusters in which data point $i$ is not a member.

The silhouette score is used to validate the USML models. The silhouette score measures how similar a data point is to its own cluster (cohesion) compared to other clusters (separation). The silhouette score ranges from -1 to +1. A high value indicates that the object is well matched to its own cluster and poorly matched to neighboring clusters. If most data points of a cluster have a high silhouette score value, then the clustering configuration, namely, the elbow point cluster number, may be deemed appropriate for a particular USML model. In one or more embodiments, a set of elbow point cluster numbers corresponding to the set of USML models may be obtained. Further, a respective silhouette score may be determined for the clusters of the data points generated by respective USML models of the set of USML models. The respective USML models may be configured with respective elbow point cluster numbers of the corresponding set of elbow cluster numbers. A highest silhouette score value may be obtained from the respective silhouette scores. The USML model and the corresponding elbow point cluster number corresponding to, or generating, the highest silhouette score value may be selected.

In Block 414, the USML model with the highest silhouette score and corresponding elbow point cluster number are selected. In one or more embodiments, the USML model and the corresponding optimum cluster parameter corresponding to a highest silhouette score value is selected as the selected USML model.

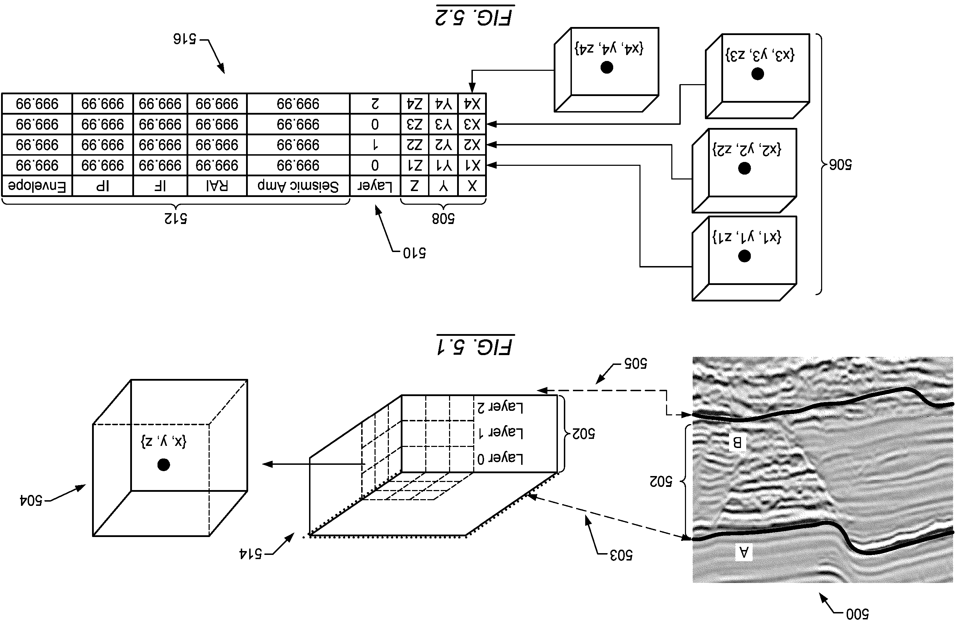

FIG. 5.1 shows an example of sampling seismic data from a vertical section of a seismic volume to generate a 3D grid representation, in accordance with one or more embodiments. The following example is for explanatory purposes only and not intended to limit the scope of one or more embodiments. Block 500 shows a seismic image, in which a seismic volume is selected by demarcating two surfaces. The surfaces are named, namely surface A and surface B. Section 502 shows the seismic volume section between surface A and surface B selected for generating a 3D grid representation of the seismic volume, shown in Block 514. The dotted line 505 shows the surface B of Block 500 forming the lower layer boundary of Block 514. Likewise, the dotted line 503 shows the surface A of Block 500 forming the upper layer boundary of Block 514. The seismic volume between surface A and surface B of Block 500 is divided into layers in the 3D grid representation of Block 514, shown as Layer 0, Layer 1, Layer 2, *etc.* The 3D grid representation thus includes a set of layers. Within each layer, seismic cells are constructed, including seismic cell attributes. The seismic cells are volumetric units of the seismic volume, shown in a 3D grid layout of Block 514. Block 504 is an expanded view of a seismic cell. The seismic cell coordinates of Block 504 are the cardinal coordinates of a centroid of the seismic cell with respect to Block 514.

FIG. 5.2 shows an example of mapping a seismic cell of a 3D grid representation of a seismic volume to a linear dataset, in accordance with one or more embodiments. The following example is for explanatory purposes only and not intended to limit the scope of one or more embodiments. Reference numeral 506 indicates a group of seismic cells with coordinates {x1, y1, z1}, {x2, y2, z2}, *etc.* Table 516 is a seismic dataset of data points obtained from the group 506 of seismic cells. A row of table 516 corresponds to a data point. Section 508 of table 516 shows the seismic cell coordinates as columns of the table. Section 510 shows the layer of the 3D grid from which each of the seismic cells from group 506 originate. Section 512 of table 516 shows the seismic cell attributes of the seismic cells. Thus, the data of a seismic cell is represented by a row in table 516.

FIG. 6 shows an example of an elbow point in a graph of distortion scores of clusters of a USML model, in accordance with one or more embodiments. The following example is for explanatory purposes only and not intended to limit the scope of one or more embodiments. Graph 602 is a graph of distortion scores plotted for a range of cluster numbers. The USML model used is the K-means clustering model. The number of clusters is plotted along the X-axis of graph 602, and the distortion scores are plotted along the left Y-axis. Point 604 indicates the elbow point of the graph. Graph 602 shows that as the cluster numbers increase after the elbow point, the gradient improvement in distortion score decreases. Thus, the elbow point cluster number of graph 602 is determined to be 5.

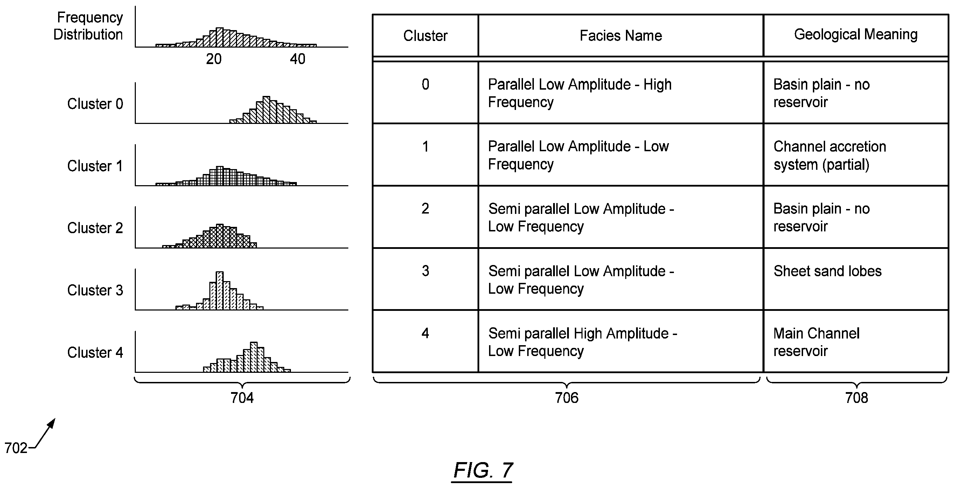

FIG. 7 shows an example of cluster profiles of a set of clusters generated by a USML model, classified by seismic facies label, and annotated with a geological description, in accordance with one or more embodiments. The following example is for explanatory purposes only and not intended to limit the scope of one or more embodiments.

Section 702 shows the different clusters obtained from the USML model, namely, five clusters, numbered 0 through 4. Section 704 shows the different frequency distributions of seismic cell attributes of data points in clusters 0 through 4. A reference frequency distribution of the seismic cell attributes of the seismic dataset is shown at the top of section 704. Section 706 shows assigned seismic facies names, or labels to each of clusters 0 through 4. The cluster profiles of section 704 may be compared with geological data of the seismic volume to obtain geological descriptions corresponding to the cluster profiles. The clusters are updated with annotations shown in section 708. The annotations of section 708 may be obtained from geological data of the seismic volume and the exploration site.

FIG. 8 shows an example of a visualization of a seismic image overlaid with a seismic facies model of a seismic volume of the image. The following example is for explanatory purposes only and not intended to limit the scope of one or more embodiments. Section 802 shows the seismic volume selected from the seismic image. Section 804 shows the same seismic volume, now overlaid with the seismic facies model. The clusters of the seismic facies model are shown in different shades and patterns.

The identification of seismic facies obtained by USML model clustering of data points of seismic attributes and coordinates employs a 3D approach that transforms seismic data into tabular data points to generate more precise results. The USML model-assisted seismic facies classification may be sampled back in comparable resolution to the seismic volume. Geological interpretation may be merged with the seismic facies model to offer valuable insights into reservoir distribution, heterogeneity, and exploration potential. USML model-assisted seismic facies classification facilitates regional exploration screening where well information is scarce. The methods disclosed reduce risks for exploration prospecting where well data is not readily available, and minimize errors for well placement and drilling.

One or more embodiments may be implemented on a computing system specifically designed to achieve an improved technological result. When implemented in a computing system, the features and elements of the disclosure provide a significant technological advancement over computing systems that do not implement the features and elements of the disclosure. Any combination of mobile, desktop, server, router, switch, embedded device, or other types of hardware may be improved by including the features and elements described in the disclosure.

For example, as shown in FIG. 9.1, the computing system (900) may include one or more computer processor(s) (902), non-persistent storage device(s) (904), persistent storage device(s) (906), a communication interface (908) (*e.g.*, Bluetooth interface, infrared interface, network interface, optical interface, *etc.*), and numerous other elements and functionalities that implement the features and elements of the disclosure. The computer processor(s) (902) may be an integrated circuit for processing instructions. The computer processor(s) (902) may be one or more cores, or micro-cores, of a processor. The computer processor(s) (902) includes one or more processors. The computer processor(s) (902) may include a central processing unit (CPU), a graphics processing unit (GPU), a tensor processing unit (TPU), combinations thereof, *etc.*

The input device(s) (910) may include a touchscreen, keyboard, mouse, microphone, touchpad, electronic pen, or any other type of input device. The input device(s) (910) may receive inputs from a user that are responsive to data and messages presented by the output device(s) (912). The inputs may include text input, audio input, video input, *etc.,* which may be processed and transmitted by the computing system (900) in accordance with one or more embodiments. The communication interface (908) may include an integrated circuit for connecting the computing system (900) to a network (not shown) (*e.g.,* a local area network (LAN), a wide area network (WAN) such as the Internet, mobile network, or any other type of network) or to another device, such as another computing device, and combinations thereof.

Further, the output device(s) (912) may include a display device, a printer, external storage, or any other output device. One or more of the output device(s) (912) may be the same or different from the input device(s) (910). The input device(s) (910) and output device(s) (912) may be locally or remotely connected to the computer processor(s) (902). Many different types of computing systems exist, and the aforementioned input device(s) (910) and output device(s) (912) may take other forms. The output device(s) (912) may display data and messages that are transmitted and received by the computing system (900). The data and messages may include text, audio, video, *etc.,* and include the data and messages described above in the other figures of the disclosure.

Software instructions in the form of computer readable program code to perform embodiments may be stored, in whole or in part, temporarily or permanently, on a non-transitory computer readable medium such as a solid state drive (SSD), compact disk (CD), digital video disk (DVD), storage device (e.g., a physical storage device), a diskette, a tape, flash memory, physical memory, or any other computer readable storage medium. Specifically, the software instructions may correspond to computer readable program code that, when executed by the computer processor(s) (902), is configured to perform one or more embodiments, which may include transmitting, receiving, presenting, and displaying data and messages described in the other figures of the disclosure.

The computing system (900) in FIG. 9.1 may be connected to, or be a part of, a network. For example, as shown in FIG. 9.2, the network (920) may include multiple nodes (*e.g.,* node X (922) and node Y (924), as well as extant intervening nodes between node X (922) and node Y (924)). Each node may correspond to a computing system, such as the computing system shown in FIG. 9.1, or a group of nodes combined may correspond to the computing system shown in FIG. 9.1. By way of an example, embodiments may be implemented on a node of a distributed system that is connected to other nodes. By way of another example, embodiments may be implemented on a distributed computing system having multiple nodes, where each portion may be located on a different node within the distributed computing system. Further, one or more elements of the aforementioned computing system (900) may be located at a remote location and connected to the other elements over a network.

The nodes (*e.g.*, node X (922) and node Y (924)) in the network (920) may be configured to provide services for a client device (926). The services may include receiving requests and transmitting responses to the client device (926). For example, the nodes may be part of a cloud computing system. The client device (926) may be a computing system, such as the computing system shown in FIG. 9.1. Further, the client device (926) may include or perform all or a portion of one or more embodiments.

The computing system of FIG. 9.1 may include functionality to present data (including raw data, processed data, and combinations thereof) such as results of comparisons and other processing. For example, presenting data may be accomplished through various presenting methods. Specifically, data may be presented by being displayed in a user interface, transmitted to a different computing system, and stored. The user interface may include a graphical user interface (GUI) that displays information on a display device. The GUI may include various GUI widgets that organize what data is shown, as well as how data is presented to a user. Furthermore, the GUI may present data directly to the user, *e.g.*, data presented as actual data values through text, or rendered by the computing device into a visual representation of the data, such as through visualizing a data model.

As used herein, the term "connected to" contemplates multiple meanings. A connection may be direct or indirect (*e.g.*, through another component or network). A connection may be wired or wireless. A connection may be a temporary, permanent, or a semi-permanent communication channel between two entities.

The various descriptions of the figures may be combined and may include, or be included within, the features described in the other figures of the application. The various elements, systems, components, and steps shown in the figures may be omitted, repeated, combined, or altered as shown in the figures. Accordingly, the scope of the present disclosure should not be considered limited to the specific arrangements shown in the figures.

In the application, ordinal numbers (*e.g.,* first, second, third, *etc.*) may be used as an adjective for an element (*i.e.*, any noun in the application). The use of ordinal numbers is not to imply or create any particular ordering of the elements, nor to limit any element to being only a single element unless expressly disclosed, such as by the use of the terms "before," "after," "single," and other such terminology. Rather, ordinal numbers distinguish between the elements. By way of an example, a first element is distinct from a second element, and the first element may encompass more than one element and succeed (or precede) the second element in an ordering of elements.

Further, unless expressly stated otherwise, the conjunction "or" is an inclusive "or" and, as such, automatically includes the conjunction "and," unless expressly stated otherwise. Further, items joined by the conjunction "or" may include any combination of the items with any number of each item, unless expressly stated otherwise.

As used herein, the term "if" may be construed to mean "when" or "upon" or "in response to determining" or "in response to detecting," depending on the context.

One of ordinary skill in the art will appreciate that while some terms as used herein may refer to absolutes, *e.g.*, all of the elements of a set, each of a multitude of objects, *etc.,* the methods and techniques disclosed herein may also be performed on fewer than all of a given thing, *e.g.*, performed on one or more components. Accordingly, in instances in the specification where an absolute is used, the instances may also be interpreted to be referring to a subset.

In the above description, numerous specific details are set forth in order to provide a more thorough understanding of the disclosure. However, it will be apparent to one of ordinary skill in the art that the technology may be practiced without these specific details. In other instances, well-known features have not been described in detail to avoid unnecessarily complicating the description. Further, other embodiments not explicitly described above can be devised which do not depart from the scope of the claims as disclosed herein. Accordingly, the scope should be limited only by the attached claims.

**Claims**

1. A method comprising:

   obtaining a seismic dataset comprising a plurality of data points, wherein a data point of the seismic dataset comprises one or more seismic cell attributes obtained from seismic data of a seismic volume of an exploration site;
   selecting an unsupervised machine learning (USML) model from a set of USML models by processing a test dataset with the set of USML models, wherein respective USML models of the set of USML models are configured with a plurality of cluster numbers, to obtain a selected USML model and a corresponding elbow point cluster number;
   processing the seismic dataset by the selected USML model configured with the corresponding elbow point cluster number to obtain clusters of the data points, wherein a count of the clusters is the corresponding elbow point cluster number of the selected USML model;
   generating cluster profiles corresponding to the clusters of the data points based on the seismic cell attributes of the data points of each cluster;
   assigning a seismic facies label to each cluster of the data points based on the corresponding cluster profile to obtain labeled clusters of the data points;
   comparing the cluster profiles with geological data of the exploration site to obtain a geological description for each labeled cluster, and annotating each labeled cluster with the geological description to obtain labeled annotated clusters;
   sampling the labeled annotated clusters to a three-dimensional (3D) grid representation of the seismic data to obtain a seismic facies model of the seismic volume; and

displaying the seismic facies model in a visualization tool of a seismic modeling platform.

2. The method of claim 1, further comprising:
generating, by the seismic modeling platform, a well map based on a plurality of seismic facies models of a plurality of seismic volumes of the exploration site.

3. The method of claim 1 or 2, further comprising:

sampling a seismic cell of the 3D grid representation of the seismic data;
obtaining at least a seismic cell attribute of the seismic cell;
obtaining seismic cell coordinates of the seismic cell with respect to the 3D grid; and
generating the data point of the seismic dataset comprising the seismic cell attribute and the seismic cell coordinates, to obtain the seismic dataset.

4. The method of any one of the preceding claims, further comprising:

selecting the test dataset comprising a plurality of test data points from the seismic dataset;
selecting a first USML model from the set of USML models; and
processing the test dataset by the first USML model of the set of USML models by:

setting a selected cluster number corresponding to the first USML model to a first cluster number from a range of cluster numbers,
generating, by the first USML model, a first set of clusters of test data points, wherein a cardinality of the first set of clusters is the selected cluster number, and
calculating a distortion of the test data points within each cluster of the first set of clusters, to obtain a first distortion value corresponding to the selected cluster number.

5. The method of claim 4, wherein the distortion of a test data point is determined based on a distance between the test data point and a centroid of a corresponding cluster of the test data point.

6. The method of claim 4 or 5, further comprising:

iterating the processing of the test dataset by the first USML model by setting the selected cluster number to successive cluster numbers from the range of cluster numbers in each iteration, to obtain a set of distortion values corresponding to the range of cluster numbers; and
obtaining the elbow point cluster number corresponding to the first USML model from the range of cluster numbers by selecting the cluster number for which there is an elbow point in a gradient improvement in distortion.

7. The method of any one of the preceding claims, wherein processing the test dataset with the set of USML models further comprises:

obtaining a set of elbow point cluster numbers corresponding to the set of USML models;
determining a respective silhouette score for the clusters of the data points generated by respective USML models of the set of USML models configured with respective elbow point cluster numbers of the corresponding set of elbow point cluster numbers to obtain a highest silhouette score value; and
selecting the USML model and the corresponding elbow point cluster number corresponding to the highest silhouette score value,
wherein the respective silhouette score is preferably determined based on a mean intra-cluster distance of the data points within a cluster, and a smallest mean distance to the data points not within the cluster.

8. A method for obtaining a seismic facies model of a seismic volume, comprising:

selecting a test dataset comprising a plurality of test data points from a seismic dataset comprising a plurality of data points;
processing the test dataset with a first USML model of a set of USML models by:

setting a selected cluster number corresponding to the first USML model to a first cluster number from a range of cluster numbers,

generating, by the first USML model, a first set of clusters of test data points, wherein a cardinality of the first set of clusters is the selected cluster number, and

calculating a distortion of the test data points within each cluster of the first set of clusters, to obtain a first distortion value corresponding to the selected cluster number;

iterating the processing of the test dataset by the first USML model by setting the selected cluster number in each iteration to successive cluster numbers from the range of cluster numbers, to obtain a set of distortion values corresponding to the range of cluster numbers;

obtaining a set of elbow point cluster numbers corresponding to the set of USML models based on sets of distortion values corresponding to respective USML models of the set of USML models;

selecting a USML model and the corresponding elbow point cluster number corresponding to a highest silhouette score value as a selected USML model;

processing the seismic dataset by the selected USML model to obtain clusters of the data points, wherein a count of the clusters is the corresponding elbow point cluster number of the selected USML model;

generating cluster profiles corresponding to the clusters of the data points based on seismic cell attributes of the data points of each cluster;

assigning a seismic facies label to each cluster of the data points based on the corresponding cluster profile to obtain labeled clusters of the data points;

comparing the cluster profiles with geological data of an exploration site to obtain a geological description for each labeled cluster, and annotating each labeled cluster with the geological description to obtain labeled annotated clusters;

sampling the labeled annotated clusters to a three-dimensional (3D) grid representation of the seismic data to obtain a seismic facies model of the seismic volume; and

displaying the seismic facies model in a visualization tool of a seismic modeling platform, preferably further comprising:

obtaining the seismic dataset comprising a plurality of data points, wherein a data point comprises one or more seismic cell attributes of the seismic volume.

9. The method of claim 8, further comprising:

obtaining an elbow point cluster number corresponding to the first USML model from the range of cluster numbers, by selecting the cluster number for which there is an elbow point in a gradient improvement in distortion.

10. The method of claim 8 or 9, further comprising:

determining a respective silhouette score for the clusters of the test data points generated by respective USML models of the set of USML models, configured with respective elbow point cluster numbers of the corresponding set of elbow point cluster numbers, to obtain the highest silhouette score value.

11. A system comprising:

at least one computer processor;

a data repository stored on a physical storage device;

a seismic modeling platform, executing on the at least one computer processor and configured to:

obtain a seismic dataset comprising a plurality of data points, wherein a data point of the seismic dataset comprises one or more seismic cell attributes obtained from seismic data of a seismic volume of an exploration site,

process the seismic dataset by a selected USML model to obtain clusters of the data points, wherein a count of the clusters is a corresponding elbow point cluster number of the selected USML model,

generate cluster profiles corresponding to the clusters of the data points based on the seismic cell attributes of the data points of each cluster, assign a seismic facies label to each cluster of the data points based on the corresponding cluster profile to obtain labeled clusters of the data points,

compare the cluster profiles with geological data of the exploration site to obtain a geological description for each labeled cluster, and annotate each labeled cluster with the geological description to obtain labeled annotated clusters,

sample the labeled annotated clusters to a 3D grid representation of the seismic data to obtain a seismic facies model of the seismic volume, and

display the seismic facies model in a visualization tool; and

preferably cause the seismic modeling platform executing on the at least one computer processor to generate a well map based on a plurality of seismic facies models of a plurality of seismic volumes of the exploration site; and

a USML platform, executing on the at least one computer processor and configured to:
select the USML model from a set of USML models by processing a test dataset with the set of USML models, wherein respective USML models of the set of USML models are configured with a plurality of cluster numbers, to obtain the selected USML model and the corresponding elbow point cluster number.

12. The system of claim 11, further configured to cause the seismic modeling platform executing on the at least one computer processor to:

sample a seismic cell from the 3D grid representation of the seismic data;
obtain at least a seismic cell attribute of the seismic cell;
obtain seismic cell coordinates of the seismic cell with respect to the 3D grid representation; and
generate the data point of the seismic dataset comprising the seismic cell attribute and the seismic cell coordinates, to obtain the seismic dataset.

13. The system of claim 11 or 12, further configured to cause the USML platform executing on the at least one computer processor to:

select the test dataset comprising a plurality of test data points from the seismic dataset;
select a first USML model from the set of USML models; and
process the test dataset by a first USML model of the set of USML models by: setting a selected cluster number corresponding to the first USML model to a first cluster number from a range of cluster numbers,

generating, by the first USML model, a first set of clusters of test data points, wherein a cardinality of the first set of clusters is the selected cluster number, and
calculating a distortion of the test data points within each cluster of the first set of clusters, to obtain a first distortion value corresponding to the selected cluster number,
wherein the distortion of a test data point is preferably determined based on a distance between the test data point and a centroid of a corresponding cluster of the test data point.

14. The system of claim 13, further configured to cause the USML platform executing on the at least one computer processor to:

iterate the processing of the test dataset by the first USML model by setting the selected cluster number to successive cluster numbers from the range of cluster numbers in each iteration, to obtain a set of distortion values corresponding to the range of cluster numbers; and
obtain the elbow point cluster number corresponding to the first USML model from the range of cluster numbers by selecting the cluster number for which there is an elbow point in a gradient improvement in distortion.

15. The system of any one of the claims 11 - 14, further configured to cause the USML platform executing on the at least one computer processor to process the test dataset with the set of USML models by:

obtaining a set of elbow point cluster numbers corresponding to the set of USML models;
determining a respective silhouette score for the clusters of the data points generated by respective USML models of the set of USML models configured with respective elbow point cluster numbers of the corresponding set of elbow point cluster numbers to obtain a highest silhouette score value; and
selecting the USML model and the corresponding elbow point cluster number corresponding to the highest silhouette score value,
wherein the respective silhouette score is preferably determined based on a mean intra-cluster distance of the data points within a cluster, and a smallest mean distance to the data points not within the cluster.

*FIG. 1*

*FIG. 2*

EP 4 617 733 A1

300

```
                          START

OBTAIN A SEISMIC DATASET INCLUDING DATA POINTS HAVING SEISMIC CELL ATTRIBUTES
        FROM A 3D GRID REPRESENTATION OF A SEISMIC VOLUME 302

SELECT A TEST DATASET FROM THE SEISMIC DATASET, AND PROCESS THE TEST DATASET
BY A SET OF UNSUPERVISED MACHINE LEARNING (USML) MODELS TO OBTAIN A SELECTED
    USML MODEL AND A CORRESPONDING ELBOW POINT CLUSTER NUMBER  304

PROCESS, ACCORDING TO THE ELBOW POINT CLUSTER NUMBER, THE SEISMIC DATASET
BY THE SELECTED USML MODEL TO OBTAIN CLUSTERS OF DATA POINTS OF THE SEISMIC
                          DATASET 306

GENERATE A CLUSTER PROFILE FOR EACH CLUSTER OF THE SEISMIC CELL ATTRIBUTES
OF THE DATA POINTS IN EACH CLUSTER, WITH RESPECT TO THE SEISMIC DATASET   308

ASSIGN A SEISMIC FACIES LABEL TO EACH CLUSTER  BASED ON THE CLUSTER PROFILE
CHARACTERISTICS OF THE CLUSTER, AND ANNOTATE EACH CLUSTER WITH A GEOLOGICAL
       DESCRIPTION BY COMPARING THE CLUSTER PROFILE OF EACH CLUSTER WITH
          GEOLOGICAL DATA OF THE SEISMIC VOLUME  310

MAP THE LABELED ANNOTATED CLUSTERS TO THE  3D GRID REPRESENTATION TO OBTAIN
        A  SEISMIC FACIES MODEL OF THE SEISMIC VOLUME  312

DISPLAY THE SEISMIC FACIES MODEL OF THE SEISMIC VOLUME IN A VISUALIZATION TOOL
                          314

GENERATE A WELL PLAN  BASED ON THE SEISMIC FACIES MODEL OF THE SEISMIC VOLUME
                          316

                           END
```

*FIG. 3*

START

400

OBTAIN A TEST DATASET OF DATA POINTS FROM THE SEISMIC DATASET 402

SELECT A SET OF USML MODELS 404

PROCESS THE TEST DATASET BY EACH USML MODEL IN MULTIPLE ITERATIONS, BY VARYING A CLUSTER NUMBER IN EACH ITERATION 406

DETERMINE A DISTORTION OF THE DATA POINTS WITHIN EACH CLUSTER FOR A GIVEN CLUSTER NUMBER, FOR THE RANGE OF CLUSTER NUMBERS USED BY A USML MODEL 408

OBTAIN AN ELBOW POINT CLUSTER NUMBER CORRESPONDING TO EACH USML MODEL BY SELECTING THE CLUSTER NUMBER FOR WHICH THERE IS AN ELBOW POINT IN THE GRADIENT IMPROVEMENT IN DISTORTION, FROM THE RANGE OF CLUSTER NUMBERS USED BY THE USML MODEL 410

DETERMINE A SILHOUETTE SCORE FOR EACH USML MODEL WITH RESPECT TO THE RESPECTIVE ELBOW POINT CLUSTER NUMBER OF THE USML MODEL 412

SELECT THE USML MODEL WITH THE HIGHEST SILHOUETTE SCORE AND THE CORRESPONDING ELBOW POINT CLUSTER NUMBER 414

END

_FIG. 4_

*FIG. 5.1*

*FIG. 5.2*

FIG. 6

| Cluster | Facies Name | Geological Meaning |
|---|---|---|
| 0 | Parallel Low Amplitude - High Frequency | Basin plain - no reservoir |
| 1 | Parallel Low Amplitude - Low Frequency | Channel accretion system (partial) |
| 2 | Semi parallel Low Amplitude - Low Frequency | Basin plain - no reservoir |
| 3 | Semi parallel Low Amplitude - Low Frequency | Sheet sand lobes |
| 4 | Semi parallel High Amplitude - Low Frequency | Main Channel reservoir |

*FIG. 7*

FIG. 8

900

```
┌─────────────────────────────┐
│            912              │
│       OUTPUT DEVICE(S)       │
└─────────────────────────────┘
              ↕
┌───────────────────────────────────────────┐
│  ┌──────────────┐    ┌──────────────────┐  │
│  │     904      │    │       902        │  │
│  │NON-PERSISTENT│    │    COMPUTER      │  │
│  │   STORAGE    │    │  PROCESSOR(S)    │  │
│  └──────────────┘    └──────────────────┘  │
│  ┌──────────────┐    ┌──────────────────┐  │
│  │     906      │    │       908        │  │
│  │  PERSISTENT  │    │  COMMUNICATION   │  │
│  │   STORAGE    │    │    INTERFACE     │  │
│  └──────────────┘    └──────────────────┘  │
└───────────────────────────────────────────┘
              ↕
┌─────────────────────────────┐
│            910              │
│       INPUT DEVICE(S)        │
└─────────────────────────────┘
```

*FIG. 9.1*

```
              920
            NETWORK
  ┌──────────────┐        ┌──────────────┐
  │     922      │ ● ● ●  │     924      │
  │    NODE X    │        │    NODE Y    │
  └──────────────┘        └──────────────┘
                  ↕
          ┌──────────────┐
          │     926      │
          │ CLIENT DEVICE │
          └──────────────┘
```

*FIG. 9.2*

Europäisches
Patentamt

European
Patent Office

Office européen
des brevets

# EUROPEAN SEARCH REPORT

**Application Number**

EP 25 16 3916

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Ting Jimmy ET AL: "PROCEEDINGS, INDONESIAN PETROLEUM ASSOCIATION Forty-Sixth Annual Convention & Exhibition, September 2022 LEVERAGING UNSUPERVISED MACHINE LEARNING ON SEISMIC IMAGES OF MIOCENE DEPOSITS IN THE CARPATHIAN FOREDEEP BASIN FOR FACIES CLASSIFICATION", , 30 April 2022 (2022-04-30), XP093293224, Retrieved from the Internet: URL:https://www.researchgate.net/publicati on/390991557_LEVERAGING_UNSUPERVISED_MACHI NE_LEARNING_ON_SEISMIC_IMAGES_OF_MIOCENE_D EPOSITS_IN_THE_CARPATHIAN_FOREDEEP_BASIN_F OR_FACIES_CLASSIFICATION | 1-6, 11-14 | INV.<br>G01V1/20<br>G06N20/00<br>G01V1/30<br>G01V1/34 |
| A | * pages 1-14; figures 1-8 * | 7-10,15 | |
| X | BEDI JATIN ET AL: "Spark map reduce based framework for seismic facies classification", JOURNAL OF APPLIED GEOPHYSICS, ELSEVIER, AMSTERDAM, NL, vol. 205, 26 July 2022 (2022-07-26), XP087186422, ISSN: 0926-9851, DOI: 10.1016/J.JAPPGEO.2022.104762 [retrieved on 2022-07-26] | 1,3-6,8, 9,11-13 | |
| A | * pages 1-15; figures 1-10 * | 7,10,15 | TECHNICAL FIELDS SEARCHED (IPC)<br><br>G01V<br>G06N |
| A | WO 2018/071632 A1 (CHEVRON USA INC [US]) 19 April 2018 (2018-04-19) * the whole document * | 1-15 | |

The present search report has been drawn up for all claims

| Place of search | Date of completion of the search | Examiner |
|---|---|---|
| The Hague | 9 July 2025 | Gassmann, Martin |

EPO FORM 1503 03.82 (P04C01)

## ANNEX TO THE EUROPEAN SEARCH REPORT
## ON EUROPEAN PATENT APPLICATION NO.

EP 25 16 3916

This annex lists the patent family members relating to the patent documents cited in the above-mentioned European search report.
The members are as contained in the European Patent Office EDP file on
The European Patent Office is in no way liable for these particulars which are merely given for the purpose of information.

09-07-2025

| Patent document cited in search report | Publication date | Patent family member(s) | | Publication date |
|---|---|---|---|---|
| WO 2018071632 A1 | 19-04-2018 | AU | 2017343749 A1 | 11-04-2019 |
| | | CA | 3038714 A1 | 19-04-2018 |
| | | CN | 109804274 A | 24-05-2019 |
| | | EP | 3526629 A1 | 21-08-2019 |
| | | US | 2018106917 A1 | 19-04-2018 |
| | | WO | 2018071632 A1 | 19-04-2018 |

EPO FORM P0459

For more details about this annex : see Official Journal of the European Patent Office, No. 12/82

**REFERENCES CITED IN THE DESCRIPTION**

**Patent documents cited in the description**

- US 63565083